# EUROPÄISCHE PATENTSCHRIFT

(11) **EP 3 823 784 B1**
(45) Veröffentlichungstag und Bekanntmachung des Hinweises auf die Patenterteilung: **04.09.2024**
(21) Anmeldenummer: 19739655.9
(22) Anmeldetag: 18.07.2019
(51) Int. Cl.: B23K 1/002, B23K 3/047, B23K 1/00, B23K 3/06, B23K 3/08, B23K 101/36, H01R 43/02, H05B 3/84, H05B 6/10, H05B 6/14, H05B 6/40, H05B 6/42

(54) **SYSTEM UND VERFAHREN ZUM VERLÖTEN VON KONTAKTELEMENTEN MIT INDUKTIONSWÄRME**
SYSTEM AND METHOD FOR SOLDERING CONTACT ELEMENTS WITH INDUCTION HEAT
SYSTEME ET PROCÉDÉ DE SOUDAGE D'ÉLÉMENTS DE CONTACT PAR CHALEUR D'INDUCTION

(30) Priorität: 20.07.2018 EP 18184600
(43) Veröffentlichungstag der Anmeldung: 26.05.2021
(73) Patentinhaber: Saint-Gobain Glass France, 92400 Courbevoie (FR)
(72) Erfinder: REUL, Bernhard, 52134 Herzogenrath (DE); HALM, Cynthia, 52074 Aachen (DE)
(74) Vertreter: Gebauer, Dieter Edmund
(86) Internationale Anmeldenummer: PCT/EP2019/069393
(87) Internationale Veröffentlichungsnummer: WO 2020/016367

(56) Entgegenhaltungen:
- DE-A1- 102015 003 086
- DE-B3- 102004 057 630
- US-A1- 2007 105 341

## Beschreibung

Die Erfindung betrifft ein System und ein Verfahren zum Verlöten von Kontaktelementen mit Leiterstrukturen auf nichtmetallischen Scheiben mit Induktionswärme.

Moderne Automobil- oder Bauverglasungen verfügen oftmals über eine Vielzahl von elektrischen Funktionen, wie Antennen, elektrische Heizungen oder elektrischen Leuchtelementen. Diese werden in der Regel durch Leiterstrukturen mit Lötanschlussflächen auf der Scheibenoberfläche kontaktiert. Die Leiterstrukturen bestehen dabei meist aus einer wohlbekannten eingebrannten Dickschicht aus einer Siebdruckpaste mit relativ hohem Silberanteil.

Anschließend werden Kontaktelemente über ein Lot mit den Leiterstrukturen verlötet. Das Lot bildet dabei einen elektrischen Anschluss und oftmals auch eine mechanische Verbindung zwischen den Leiterstrukturen und den Zuleitungen, die mit dem Kontaktelement verbunden sind.

Der Lötvorgang kann beispielsweise durch ein Kontaktlötverfahren erfolgen, bei dem zwei Elektroden mit einem gewissen Abstand voneinander auf das elektrisch leitfähige Kontaktelement aufgesetzt werden. Anschließend wird das Kontaktelement durch einen elektrischen Strom, der von einer Elektrode zur anderen fließt, mittels ohmscher Widerstandsheizung erwärmt.

Alternativ kann der Lötvorgang durch Induktionslöten erfolgen. Dabei wird beispielsweise ein Magnetfeld durch eine Spule, die sich auf der der Leiterstruktur abgewandten Oberfläche der Scheibe befindet, ein hochfrequentes Magnetfeld in die Leiterstruktur, das Lot und das Kontaktelement eingekoppelt. Dazu nutzt man das Vermögen des Magnetfelds, die zum Aufschmelzen des Lotes benötigte Energie kontaktlos durch die Scheibe hindurch zu übertragen. Ein derartiges Verfahren ist beispielsweise aus der DE 10 2004 057 630 B3 bekannt, welche die Basis für den Oberbegriff des Anspruchs 1 bildet.

Weitere Vorrichtungen oder Verfahren zum induktiven Erwärmen oder Löten sind beispielsweise aus der US 2007/105341 A1 oder der DE 10 2015 003086 A1 bekannt.

Der vorliegenden Erfindung liegt nunmehr die Aufgabe zu Grunde, ein verbessertes System zum induktiven Verlöten von Kontaktelementen mit Leiterstrukturen auf Scheiben sowie ein Verfahren dazu anzugeben.

Diese Aufgabe wird erfindungsgemäß mit den Merkmalen des Patentanspruchs 1 gelöst. Die Merkmale der Unteransprüche geben vorteilhafte Weiterbildungen der Erfindung an.

Das erfindungsgemäße System zum induktiven Verlöten (auch Induktionslötsystem genannt), umfasst:
- mindestens ein ferromagnetisches Kontaktelement,
- mindestens eine Leiterstruktur, welche auf einer nichtmetallischen Scheibe angeordnet ist, und
- eine Vorrichtung zum induktiven Verlöten des mindestens einen ferromagnetischen Kontaktelements mit der mindestens einen Leiterstruktur auf der nichtmetallischen Scheibe.

Die Vorrichtung zum induktiven Verlöten mindestens eines ferromagnetischen Kontaktelements mit mindestens einer Leiterstruktur auf einer nichtmetallischen Scheibe, umfasst:
- Mittel zum Festlegen einer Scheibe während des Lötvorgangs,
- mindestens ein Lötwerkzeug mit mindestens einer zum Abstrahlen eines Magnetfeldes geeigneten Induktionsschleife oder Induktionsspule,
- Mittel zum gegenseitigen Positionieren des Lötwerkzeugs und des Kontaktelements derart, dass das eingeschaltete Magnetfeld des Lötwerkzeugs das Kontaktelement zumindest abschnittsweise erwärmt,
- einen zum Erzeugen einer Wechselspannung mit einer Frequenz von bis zu 1500 kHz, bevorzugt von 5 kHz bis 1100 kHz geeigneten, mit der Induktionsschleife oder Induktionsspule verbindbaren oder verbundenen Generator.

Das Lötwerkzeug umfasst, neben der Induktionsschleife oder Induktionsspule, keine Bauelemente zum Lenken und Führen der Feldlinien des Magnetfeldes. Die Abmessungen der mindestens einen Induktionsschleife oder Induktionsspule entsprechen im Wesentlichen der Länge und Breite des Kontaktelements über der Lötstelle.

In einer vorteilhaften Ausgestaltung des Lötwerkzeugs, weist die Induktionsspule oder die Induktionsschleife kein magnetisches und bevorzugt kein weichmagnetisches Material auf. Weichmagnetische Werkstoffe sind ferromagnetische Materialien und lassen sich in einem Magnetfeld leicht magnetisieren. Insbesondere weist die Induktionsschleife oder Induktionsspule in ihrem Wirkungsbereich kein weichmagnetisches oder ferromagnetisches Material auf, außer einem gegebenenfalls zu verlötenden weichmagnetischen Bauelement, wie einem weichmagnetischen Kontaktelement, weichmagnetischem Lot, weichmagnetischen Leiterstrukturen und/oder deren Zuleitung oder Zuleitungen. Der Wirkungsbereich ist hier der Bereich, in den das Induktionsfeld zum Verlöten abstrahlt, d.h. der Umgebungsbereich der Induktionsschleife, in dem ein zu lötendes Bauelement erwärmt werden kann. Es versteht sich, dass die zu verlötenden Bauelemente und Strukturen nicht Teil der Induktionsschleife oder Induktionsspule sind.

Die Erfindung beruht auf der Erkenntnis der Erfinder, dass es - bei Verwendung von Kontaktelementen aus ferromagnetischem Stahl, insbesondere ferromagnetischem rostfreien Stahl - möglich ist, das durch das Lötwerkzeug erzeugte Induktionsfeld ohne weitere Führung der Feldlinien in das Kontaktelement einzukoppeln.

In den metallischen und insbesondere ferromagnetischen Bestandteilen des Kontaktelements entsteht Wärme, die das angrenzende Lotdepot und die daran angrenzende Leiterstruktur erwärmt und dadurch eine Lötstelle ausbildet.

Das erfindungsgemäße Verfahren hat den besonderen Vorteil, dass gezielt das Kontaktelement und das daran angrenzende Lotdepot erwärmt wird und die Umgebung der Leiterstruktur um die erste Lötanschlussfläche hingegen nur gering erwärmt wird. Dies ist insbesondere bei Leiterstrukturen aus aufgedruckten und eingebrannten Silberdrucken besonders vorteilhaft, da diese besonders temperaturempfindlich sind und bei übermäßiger Erwärmung sich von ihrer Unterlage (hier insbesondere von der nichtmetallischen Scheibe) ablösen können.

Besonders geeignet sind dazu Kontaktelemente aus ferromagnetischen Stählen mit einem µᵣ>>1, bevorzugt nichtrostenden ferromagnetischen Stahl. Zu dieser Gruppe gehören insbesondere ferritische Stähle und nichtrostende ferritische Stähle, martensitische Stähle und nichtrostende martensitische Stähle sowie Duplexstähle und nichtrostende Duplexstähle. Als Duplexstahl bezeichnet man einen Stahl, der ein zweiphasiges Gefüge aufweist, das aus einer Ferrit-(α-Eisen-)Matrix mit Inseln aus Austenit besteht. Die Polarisation dieser Stähle neigt hier dazu, sich an das externe Feld an zu gleichen, es zu kanalisieren und zu verstärken.

Es versteht sich, dass es genügt, wenn das Kontaktelement eine ausreichende große Menge an ferromagnetischem Stahl enthält. Das heißt, es können beispielsweise noch weitere dünne Schichten aus anderen Metallen angeordnet sein, z.B. zum Korrosionsschutz oder Rostschutz, auf dem Kontaktelement oder zur Verbesserung der elektrischen Leitfähigkeit oder Benetzbarkeit durch ein Lot. Zusätzlich kann das Kontaktelement noch weitere nichtmetallische Bestandteile enthalten, beispielsweise ein Gehäuse aus einem temperaturbeständigen Kunststoff oder einer Keramik. Besonders bevorzugt ist es, wenn das Kontaktelement vollständig aus ferromagnetischem nichtrostendem Stahl besteht.

Die Leiterstruktur auf der Scheibe enthält eine (erste) Lötanschlussfläche. Das Kontaktelement enthält eine (zweite) Lötanschlussfläche. Die Lötanschlussflächen sind dazu geeignet, mit dem Lot aus einem Lotdepot, die Lötstelle auszubilden.

Der Wärmeeintrag erfolgt primär über das Kontaktelement. Das heißt, die Lötanschlussfläche des Kontaktelements wird unmittelbar erwärmt. In der Folge wird das an das Kontaktelement angrenzende Lotdepot erwärmt und dann erst die Lötanschlussfläche der Leiterstruktur auf der Scheibe. Dies hat mehrere entscheidende Vorteile. Durch die direkte Erwärmung des Kontaktelements wird die notwendige eingestrahlte Energie sehr zielgerichtet verwendet, so dass eine Energieersparnis im Vergleich zu Techniken des Stands der Technik erfolgt. Durch die nur indirekte Erwärmung der Lötanschlussfläche auf der Leiterstruktur der Scheibe wird diese sehr schonend erwärmt, so dass es zu weniger Beschädigungen der Leiterstruktur und der Scheibe kommt.

Es versteht sich, dass das Lötwerkzeug auch mehr als eine Induktionsspule oder Induktionsschleife aufweisen kann, beispielsweise um ein Kontaktelement mit mehreren Lotanschlussflächen (z.B. in einer Brückenkonfiguration) oder mehrere Kontaktelemente nebeneinander (z.B. in einer Multipolkonfiguration) zeitgleich zu verlöten.

Das Lötwerkzeug ist unmittelbar benachbart zum Kontaktelement und damit auf der der Lötstelle und der Leiterstruktur zugewandten Seite der Scheibe angeordnet.

Das Lötwerkzeug ist insbesondere dazu geeignet, das Kontaktelement auf oder über die Löttemperatur eines Lots zu erwärmen, so dass ein daran angrenzendes Lotdepot aufgeschmolzen und mit einer Leiterstruktur verlötet werden kann.

Zum Erzielen einer gleichbleibend hohen Lötqualität ist es vorteilhaft, den Abstand zwischen dem Lötwerkzeug und dem Kontaktelement möglichst bei jeder Scheibe gleich zu halten. Hier ist vorteilhafterweise ein sehr enger, wohldefinierter Luftspalt, bevorzugt mit einem Spaltmaß von 0,1 mm bis 5 mm, besonders bevorzugt von 0,25 mm bis 5 mm und insbesondere von 0,25 mm bis 2 mm, zwischen dem Lötwerkzeug und dem Kontaktelement vorgesehen, um eine Berührung und elektrische Kurzschlüsse gänzlich zu vermeiden.

Alternativ oder in Kombination mit einem Luftspalt kann auch das Lötwerkzeug an seiner dem Kontaktelement zugewandten Oberfläche eine elektrisch isolierende Zwischenlage oder Einhausung, beispielsweise aus einem thermisch beständigen Kunststoff oder einer Keramik aufweisen. Es versteht sich, dass in dieser Konfiguration die Scheibe selbst nicht als Zwischenlage dient.

Alternativ oder in Kombination mit dem oben genannten, kann auch das Kontaktelement an seiner dem Lötwerkzeug zugewandten Oberfläche eine elektrisch isolierende Zwischenlage oder Einhausung aufweisen, beispielsweise aus einem thermisch beständigen Kunststoff oder einer Keramik.

Die Werkzeuge können für Serienproduktionen vorteilhaft stationär in Vorrichtungen oder Lötstationen eingebaut werden, in welche die zum Herstellen der Lötanschlüsse vorbereiteten Scheiben eingelegt und positioniert werden. Die stationäre Anordnung der Lötwerkzeuge hat den weiteren Vorteil, dass benötigte Versorgungsleitungen nicht bewegt werden müssen. Alternativ kann das Lötwerkzeug beweglich ausgebildet werden und dadurch eine flexiblere Positionierung auf der Scheibe ermöglichen. Außerdem können mit einem Lötwerkzeug mehrere Anschlüsse nacheinander verlötet werden.

In einer vorteilhaften Ausgestaltung der Erfindung umfasst die Vorrichtung mindestens einen Gegenhalter zum Aufdrücken des Kontaktelements auf die Scheibe. In einer weiteren vorteilhaften Ausgestaltung der Erfindung ist der Gegenhalter mit Greifwerkzeugen zum Positionieren der Kontaktelemente kombiniert.

Die Gegenhalter oder Greifwerkzeuge werden vorteilhafterweise unabhängig vom Lötwerkzeug ausgebildet. An den Lötwerkzeugen tritt nahezu kein Verschleiß auf. Gegenhalter und Greifwerkzeuge zum Aufsetzen der zu verlötenden Bauteile können ohne Lötwerkzeug einfacher und kompakter ausgeführt und einfacher ausgetauscht werden.

Alternative Gegenhalter oder Greifwerkzeuge können vorteilhafterweise mit dem Lötwerkzeug und insbesondere mit der Induktionsschleife oder der Induktionsspule verbunden ausgebildet sein, insbesondere als Einhausung der Induktionsschleife oder der Induktionsspule. Erfindungsgemäße Gegenhalter und Greifwerkzeuge sind dazu beispielsweise elektrisch isoliert oder aus einem elektrisch isolierenden Material hergestellt.

Während des Lötvorgangs werden die Anschlussteile nur lose mithilfe von einfachen Gegenhaltern und/oder Greifwerkzeugen an die Scheibenoberfläche gedrückt, die selbst nicht durch das Magnetfeld aufgeheizt werden. Diese Werkzeuge können z. B. aus Kunststoff oder Keramik oder beidem bestehen bzw. in den Zonen ihres Kontakts zu den Lötstücken mit entsprechenden nichtmetallischen Einsätzen bestückt sein. Insbesondere bestehen die Gegenhalter nur aus nichtferromagnetischen und insbesondere nichtferritischen Werkstoffen. Dadurch kann die vom Induktionsgenerator notwendige eingekoppelte elektrische Leistung verringert werden.

In einer weiteren vorteilhaften Ausgestaltung enthält die Vorrichtung einen Roboter zum Führen und Anlegen des mindestens einen Lötwerkzeuges an die Scheibe und/oder der Scheibe an das Lötwerkzeug.

In einer weiteren vorteilhaften Ausgestaltung enthält die Vorrichtung einen Roboter zum Führen und Anlegen der Gegenhalter und/oder Greifwerkzeuge.

In einer weiteren vorteilhaften Ausgestaltung weist der Gegenhalter und/oder das Greifwerkzeug keine Bauelemente zum Lenken und Führen der Feldlinien des Magnetfeldes auf und insbesondere keine ferromagnetischen oder ferritischen Bauelemente.

In einer weiteren vorteilhaften Ausgestaltung sind in der Umgebung der Lötstelle keine Bauelemente zum Lenken und Führen der Feldlinien des Magnetfeldes und insbesondere keine ferromagnetischen oder ferritischen Bauelemente angeordnet.

In einer weiteren vorteilhaften Ausgestaltung beträgt der Frequenzbereich des Induktionsgenerators von 5 kHz bis 1100 kHz, bevorzugt von 40 kHz bis 1100 kHz, besonders bevorzugt von 400 kHz bis 1100 kHz und insbesondere von 700 kHz und 1100 kHz. Die einstellbare Ausgangsleistung des Induktionsgenerators beträgt vorteilhafterweise von 200 W bis 15 kW und bevorzugt von 400 W bis 3 kW.

Die Scheiben sind bevorzugt Einzelscheiben oder Verbundscheiben aus zwei oder mehreren Einzelscheiben, wie sie im Automobilbereich oder im Baubereich üblicherweise verwendet werden. Die Einzelscheibe oder die einzelnen Scheiben der Verbundscheibe sind bevorzugt aus Glas gefertigt, besonders bevorzugt aus Kalk-Natron-Glas, wie es für Fensterscheiben üblich ist. Die Scheiben können aber auch aus anderen Glassorten gefertigt sein, beispielsweise Quarzglas, Borosilikatglas oder Aluminosililat-Glas, oder aus starren klaren Kunststoffen, beispielsweise Polycarbonat oder Polymethylmethacrylat.

Die Leiterstrukturen können alle Arten von elektrischen Leitern umfassen, die auf einer Scheibe angeordnet werden können und die zum Verlöten geeignet sind. Dies sind insbesondere aufgedruckte Silberleiter, hergestellt aus einer aufgedruckten und anschließend eingebrannten Dickschicht aus einer Siebdruckpaste mit relativ hohem Silberanteil. Alternativ können auch aufgeklebte oder anderweitig befestigte Metalldrähte oder Metallfolien als Leiterstrukturen verwendet werden.

Ein weiterer Aspekt der Erfindung umfasst ein Verfahren zum Verlöten mindestens eines ferromagnetischen Kontaktelements mit mindestens einer Leiterstruktur auf einer nichtmetallischen Scheibe mit einem erfindungsgemäßen System, wobei
a) eine nichtmetallische Scheibe, bevorzugt aus Glas oder Kunststoff, mit mindestens einer darauf angeordneten Leiterstruktur und mindestens einer ersten Lötanschlussfläche bereitgestellt wird,
b) mindestens ein Kontaktelement aus einem ferromagnetischen Stahl mit mindestens einer zweiten Lötanschlussfläche bereitgestellt wird,
c) mindestens ein Lotdepot zumindest abschnittsweise auf der ersten Lötanschlussfläche oder der zweite Lötanschlussfläche oder auf beiden angeordnet wird,
d) die zweite Lötanschlussfläche auf der ersten Lötanschlussfläche angeordnet wird, wobei das Lotdepot zumindest abschnittsweise zwischen der ersten Lötanschlussfläche und der zweiten Lötanschlussfläche angeordnet wird,
e) ein Magnetfeld mit einer vorgegebenen Frequenz von einem eine elektrisch gespeiste Induktionsschleife oder Induktionsspule umfassenden Lötwerkzeug in das Kontaktelement abgestrahlt wird, um dieses durch Induktion zu erhitzen und das daran anliegende Lotdepot aufzuschmelzen.

In einem weiteren Verfahrensschritt wird vorteilhafterweise das Magnetfeld entfernt, beispielsweise durch Abschalten der Speisespannung oder durch Entfernen des Lötwerkzeugs, worauf das Kontaktelement und das Lot abkühlen und sich das Lot verfestigt.

In einer vorteilhaften Ausführungsform des erfindungsgemäßen Verfahrens wird die Frequenz der an die Induktionsschleife oder Induktionsspule angelegten Wechselspannung an die Anschlussgeometrie angepasst und höchstens auf 1500 kHz eingestellt.

In einer vorteilhaften Ausführungsform des erfindungsgemäßen Verfahrens wird die Frequenz des Magnetfeldes im Bereich von 5 kHz bis 1100 kHz, bevorzugt von 40 kHz bis 1100 kHz, besonders bevorzugt von 400 kHz bis 1100 kHz und insbesondere von 700 kHz und 1100 kHz. Derart hohe Frequenzen der Induktionsspannung von größer oder gleich 400 kHz und insbesondere von größer oder gleich 700 kHz führen zu einem Magnetfeld mit nur einer geringen Eindringtiefe. Dies hat den besonderen Vorteil, dass zwar das Kontaktelement, das an der zweiten Lötanschlussfläche anliegende Lotdepot und dadurch mittelbar auch die erste Lötanschlussfläche der Leiterstruktur zuverlässig erwärmt werden, jedoch die Leiterstruktur im Umgebungsbereich der ersten Lötanschlussfläche nur gering erwärmt wird. Dadurch kann eine Schädigung der Leiterstruktur und ein Ablösen der Leiterstruktur von der Scheibe zuverlässig vermieden werden.

Die Ausgangsleistung des Induktionsgenerators wird vorteilhafterweise im Bereich von 200 W bis 15 kW und bevorzugt von 200 W bis 3 kW eingestellt.

In einer vorteilhaften Ausführungsform des erfindungsgemäßen Verfahrens wird das Lötwerkzeug unmittelbar und/oder über eine elektrisch isolierende Zwischenlage (die insbesondere nicht die Scheibe selbst ist) oder mit einem engen Luftspalt an das Kontaktelement angelegt. In einer vorteilhaften Ausführungsform des erfindungsgemäßen Verfahrens wird das Kontaktelement vor und während des Verlötens mithilfe von nichtferromagnetischen, bevorzugt von nichtferromagnetischen nichtmetallischen Gegenhaltern auf der Scheibe fixiert.

In einer vorteilhaften Ausführungsform des erfindungsgemäßen Verfahrens werden die Scheibe, das Kontaktelement und das mindestens eine Lötwerkzeug zumindest während des Lötvorgangs stationär in einer Vorrichtung fixiert.

In einer vorteilhaften Ausführungsform des erfindungsgemäßen Verfahrens werden die erste Lötanschlussfläche der Leiterstruktur auf der Scheibe oder die zweite Lötanschlussfläche des Kontaktelements oder beide mit einem bleihaltigen oder bleifreien Lotdepot, bevorzugt mit integriertem oder nachträglich appliziertem Flussmittel, versehen.

In einer vorteilhaften Weiterbildung des erfindungsgemäßen Verfahrens, wird die Scheibe, insbesondere im Bereich der Lötanschlussfläche, von der dem Lötwerkzeug abgewandten Seite zusätzlich erwärmt. Dazu enthält die Vorrichtung beispielsweise eine Heizung. Durch die zusätzliche Erwärmung werden temperaturbedingte Spannungen im Bereich der Lötstelle reduziert und Glasbruch beziehungsweise eine Ablösung der Leiterstruktur von der Scheibe wird vermieden. Dies ist besonders vorteilhaft bei gläsernen Scheiben, da dort die Haftung der Leiterstruktur auf der Scheibe besonders empfindlich ist.

Weitere Einzelheiten und Vorteile der erfindungsgemäßen Lösung ergeben sich aus den beigefügten Zeichnungen von Beispielen möglicher Anwendungsfälle und aus deren eingehender Beschreibung.

Es zeigen in schematischer und nicht maßstäblicher Darstellung:
- Figur 1: eine schematische Darstellung einer Vorrichtung mit einem vergrößerten Detail einer Lötstelle und
- Figur 2: eine Ansicht einer Scheibe mit Kontaktelementen.

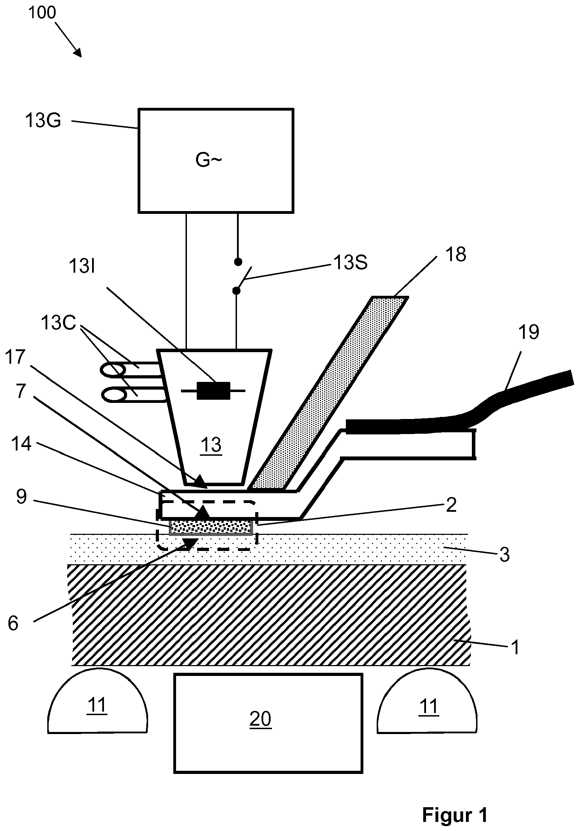

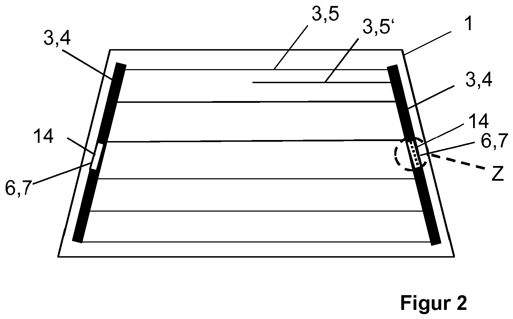

Figur 1 zeigt eine schematische Darstellung einer Vorrichtung 100 mit einem Lötwerkzeug 13 zum Verlöten eines Kontaktelements 14 mit einer Leiterstruktur 3. Figur 1 zeigt ein Detail der in Figur 2 dargestellten Scheibe 1 anhand einer Querschnittsdarstellung entlang der gepunkteten Linie im Bereich Z.

Figur 2 zeigt eine trapezflächige Scheibe 1 aus Glas oder Kunststoff, deren in Blickrichtung obenliegende Oberfläche entlang ihrem Rand mit einer opaken und beispielsweise schwarzen, elektrisch nicht leitfähigen Beschichtung versehen ist (hier der Einfachheit halber nicht dargestellt). Es handelt sich beispielsweise um eine Rückwandscheibe eines Kraftfahrzeuges, hier vereinfacht ohne Wölbung dargestellt. Auf deren Oberfläche sind des Weiteren elektrische Leiterbahnen oder -strukturen 3, beispielsweise Heizleiter 5 und Antennenleiter 5', vorgesehen, die sich über das Sichtfeld der Scheibe und/oder randseitig bis auf die opake Beschichtung erstrecken. Entlang des linken und rechten Rands der Scheibe 1 sind Sammelleiter 4 vorgesehen. Ferner sind mehrere erste Lötanschlussflächen 6 zum elektrischen Kontaktieren der Leiterstrukturen 3 über die Sammelleiter 4 vorgesehen, auf die später noch näher einzugehen sein wird. Hier ist vereinfacht eine spiegelbildlich gleiche Konfiguration von Sammelleitern und ersten Lötanschlussflächen 6 angedeutet. Die Konfigurationen der Sammelleiter und Lötanschlussflächen können real jedoch nach Scheibenseiten unterschiedlich sein. Die ersten Lötanschlussflächen 6 können auch an den Langseiten der hier gezeigten Scheibenform angeordnet sein.

Das Layout der Heizleiter 5 und Antennenleiter 5' im zentralen Sichtfeld der Scheibe 1 ist nur vereinfacht dargestellt und schränkt die Erfindung in keiner Weise ein. Für die vorliegende Beschreibung ist es ohnehin unwesentlich, denn diese soll lediglich die Herstellung der hier randseitigen elektrischen Anschlüsse der Leiterstrukturen 3 durch Löten mit induktiver Wärmeerzeugung erörtern.

Die Leiterstrukturen 3, die Sammelleiter 4 und die ersten Lötanschlussflächen 6 werden üblicherweise durch (Sieb-)Drucken einer leitfähigen (silberhaltigen) Druckpaste in Dickschichttechnik und anschließendes Einbrennen (auf Glasscheiben, vorzugsweise beim Biegen) hergestellt.

Die Scheibe 1 ist in die Vorrichtung 100 eingelegt, zu der unter anderem das Lötwerkzeug 13 und Mittel 11 zum Auflegen der Scheibe 1, sowie gegebenenfalls weitere Anschläge und Positionierungshilfen gehören. Die Auflagemittel 11 liegen hier beispielsweise in Blickrichtung hinter/unter der Scheibe 1 und das Lötwerkzeug 13 vor/über der Scheibe 1. Man erkennt insbesondere, dass das in der Vorrichtung fixierte Lötwerkzeug 13 in der vertikalen Projektion auf die Scheibenfläche über der ersten Lötanschlussfläche 6 angeordnet ist.

Des Weiteren sind Kontaktelemente 14 dargestellt. Die Kontaktelemente 14 weisen jeweils eine zweite Lötanschlussfläche 7 auf. Diese ist in der vertikalen Projektion auf die Scheibenfläche über der ersten Lötanschlussfläche 6 angeordnet ist. Zwischen der ersten Lötanschlussfläche 6 der Leiterstruktur 3 der Scheibe 1 und der zweiten Lötanschlussfläche 7 des Kontaktelements 14 ist ein Lotdepot 9 angeordnet. Nach dem Verlöten entsteht zwischen der ersten Lötanschlussfläche 6 und der zweiten Lötanschlussfläche 7 die Lötverbindung. An die Kontaktelemente 14 sind funktionsentsprechend elektrische Zuleitungen 19 wie Versorgungs- oder Anschlussleitungen bzw. Antennenkabel angeschlossen, beispielsweise durch Verklemmen (Crimpen), Punktschweissen, Schrauben oder andere Verbindungstechniken.

Die Kontaktelemente 14 enthalten beispielsweise einen ferromagnetischen nichtrostenden Edelstahl und bestehen im Wesentlichen daraus. Das heißt, das Kontaktelement 14 enthält zumindest einen Kern aus dem ferromagnetischen nichtrostenden Edelstahl. Das Kontaktelement 14 kann beispielsweise zusätzlich an der der zweiten Lötanschlussstelle 7 abgewandten Oberfläche eine Ummantelung aufweisen, vorzugsweise aus einem geeigneten (elektrisch isolierenden) Kunststoff. Des Weiteren kann das Kontaktelement 14 an den Oberflächen des Kerns noch dünne Schichten aus anderen, nicht notwendigerweise ferromagnetischen Metallen, aufweisen, beispielsweise zum verbesserten Korrosionsschutz. Auf die besondere Rolle der ferromagnetischen Eigenschaft des Kontaktelements 14 wird unten weiter eingegangen.

Das Lotdepot 9 besteht aus einer dünnen Schicht eines bleihaltigen oder bleifreien Lots, ggf. mit integriertem oder nachträglich appliziertem Flussmittel. Es kann ggf. genügen, nur auf einer der beiden jeweils zu verlötenden Flächen ein Lotdepot 9 anzulegen, also entweder auf der ersten Lötanschlussfläche 6 oder der zweiten Lötanschlussfläche 7, wenn sichergestellt wird, dass die eingetragene Energie sämtliche Bauteile hinreichend für eine gute beidseitige Verlötung erwärmen kann und die nicht verzinnte Oberfläche vom Lot benetzbar ist.

Das Kontaktelement 14, das Lotdepot 9, die Leiterstruktur 3 und die Scheibe 1 sind hier nur schematisch wiedergegeben. Das heißt insbesondere, dass die dargestellten Dicken nicht maßstäblich wiedergegeben sind.

Das Kontaktelement 14 wird hier beispielsweise durch einen oder mehrere Gegenhalter 18 auf die Scheibe 1 aufgedrückt und positioniert. Die Gegenhalter 18 können beispielsweise und vorteilhaft zugleich auch fernsteuerbare Greif- und Positionierwerkzeuge in einer automatisierten Fertigungslinie sein. Sie entnehmen die zunächst lose beweglichen Kontaktelemente 14 aus den jeweiligen Vorratsmagazinen, positionieren sie auf den zugehörigen ersten Lötanschlussflächen 6 und halten sie während des Lötvorgangs bis zum Erstarren des Lots fest.

Wie in Figur 1 dargestellt, ist das erfindungsgemäße Lötwerkzeug 13 unmittelbar über dem Kontaktelement 14 und insbesondere über der zweiten Lötanschlussfläche 7 und dem Lotdepot 9 angeordnet.

Das Lötwerkzeug 13 enthält (mindestens) eine Induktionsschleife 131 oder eine Induktionsspule, die von einem handelsüblichen Generator 13G mit einer Wechselspannung mit einstellbarer Frequenz und Leistung versorgt wird. Symbolisch ist ferner ein Schalter 13S in der Verbindung zwischen dem Generator 13G und der Induktionsschleife 13I angedeutet, mit dem der Betrieb der Induktionsschleife 131 steuerbar ist. Schließlich kann das Lötwerkzeug 13 bei Bedarf über Rohranschlüsse 13C gekühlt werden. Abweichend von der schematischen Darstellung wird man ggf. die Zufuhr des Kühlmittels und die elektrischen Speiseleitungen zusammenfassen. Beispielsweise kann die Induktionsschleife 131 oder Induktionsspule aus einem metallischen Hohlrohr bestehen, durch das das Kühlmittel fließt, und gleichzeitig als Hochfrequenz-Induktionsschleife wirkt. Das Hohlrohr kann beispielsweise aus versilbertem Kupfer bestehen.

Das im Vergleich mit herkömmlichen Hochfrequenz-Induktionsschleifen oder -spulen hier verwendete Lötwerkzeug 13 enthält, gemäß der Erfindung, Spulen oder Schleifen, deren Abmessungen im Wesentlichen der Länge und Breite des Kontaktelements 14 über der Lötstelle 2 entsprechen. Das Ausfüllen der Zwischenräume in an sich bekannter Weise mithilfe von Körpern aus Ferrit oder anderweitigen gleich geeigneten Materialien ist nicht nötig. Derartige Ferrit-freie Lötwerkzeuge 13 sind in Kombination mit ferromagnetischen Kontaktelementen 14 besonders einfach, flexibel und energiesparend verwendbar.

Durch die Anordnung des Lötwerkzeugs 13 und unmittelbar über dem ferromagnetischen Material des Kontaktelements 14 wird das vom Induktionsfeld abgestrahlte Magnetfeld im bzw. durch das Kontaktelement 14 konzentriert und so optimiert, dass es möglichst intensiv und konzentriert auf die Lötstellen 2 gelenkt wird und einwirkt. Es kommt also weniger auf das Erzielen hoher Homogenität auf großen Flächen an, als vielmehr darauf, das Magnetfeld in das besonders ausgebildete Kontaktelement 14 zu lenken. Die Erwärmung des Kontaktelements 14 führt über die zweite Lötanschlussfläche 7 zu einer raschen und intensiven Erhitzung des Lotdepots 9 und der angrenzenden ersten Lötanschlussstellen 6.

Das Lötwerkzeug 13 benötigt dabei keine besonderen Elemente, wie Ferritelemente oder funktionsgleiche Bauelemente zum Formen und Führen der Feldlinien, wie dies in Induktionslötwerkzeugen nach dem Stand der Technik der Fall ist. Auch die Gegenhalter 18 und andere etwaige Bauelemente in der Umgebung des Lötwerkzeugs 13 enthalten keine Ferrite oder ähnliches. Die Konzentration des Magnetfelds auf die Lötstelle 2 erfolgt nur über das ferromagnetische Kontaktelement 14. Dies ist besonders effizient und energieeinsparend. Gleichzeitig ist das Lötwerkzeug 13 besonders flexibel für eine Vielzahl von Anschlusskonfigurationen geeignet und muss nicht, wie nach dem Stand der Technik erforderlich, an das jeweilige Kontaktelement 14 angepasst werden.

Zum Erzielen einer gleichbleibend hohen Lötqualität ist es vorteilhaft, den Abstand zwischen dem Lötwerkzeug 13 und dem Kontaktelement 14 möglichst bei jeder Scheibe gleich zu halten. Hier ist ein sehr enger, wohldefinierter Luftspalt 17 von beispielsweise 0,5 mm zwischen dem Lötwerkzeug 13 und dem Kontaktelement 14 vorgesehen. Ein derartiger Luftspalt 17 vermeidet zuverlässig eine Berührung und elektrische Kurzschlüsse gänzlich.

Alternativ kann auch das Lötwerkzeug 13 an seiner dem Kontaktelement 14 zugewandten Oberfläche eine elektrisch isolierende Zwischenlage oder Einhausung aufweisen, beispielsweise aus einem thermisch beständigen Kunststoff oder einer Keramik.

Alternativ kann auch das Kontaktelement 14 an seiner dem Lötwerkzeug 13 zugewandten Oberfläche eine elektrisch isolierende Zwischenlage oder Einhausung aufweisen, beispielsweise aus einem thermisch beständigen Kunststoff oder einer Keramik.

Das kompakte erfindungsgemäße Lötwerkzeug 13 kann problemlos beweglich ausgebildet werden und beispielsweise mithilfe von Robotern mit reproduzierbaren Positionen an eine zu bearbeitende Scheibe angelegt werden. Dies wird man beispielsweise dann bevorzugen, wenn keine hohen Stückzahlen immer gleichbleibender Scheiben zu verarbeiten sind, oder häufige Modellwechsel auf derselben Vorrichtung zu verarbeiten sind.

Selbstverständlich kann das Lötwerkzeug 13 in der Vorrichtung 100 auch ortsfest/stationär angeordnet werden. Die jeweils zu bearbeitende Scheibe 1 dann wird mittels nicht gezeigter Fördermittel auf die Auflagemittel 11 aufgelegt und an das Lötwerkzeug 13 unter Zwischenlegen des Kontaktelements 14 herangefahren.

Zum Herstellen der Lötverbindungen wird die Induktionsschleife 13I durch Einschalten ihrer Stromversorgung (Schließen des Schalters 13S) mit Strom bzw. Spannung der gewünschten Frequenz (beispielsweise von 900 kHz) beaufschlagt. Eine typische Leistung im Bereich von 400 W bis 3 kW wird eingestellt. Es versteht sich, dass die Frequenz und die Leistung je nach Spulen- oder Schleifenabstand, (Gesamt-)Fläche der Lötstellen und der zu erwärmenden Massen variiert werden können. Das Magnetfeld durchdringt den Luftspalt 17 oder eventuelle Zwischenlagen ohne übermäßige Dämpfung. Die Dämpfung ist umso geringer, je weniger Luftspalte bzw. Zwischenlagenmaterial vorliegen.

In den metallischen und insbesondere ferromagnetischen Bestandteilen des Kontaktelements 14 entsteht Wärme, die das angrenzende Lotdepot 9 erwärmt.

Eine hohe Frequenz der Induktionsspannung von über 400 kHz und beispielsweise von 900 kHz führt zu einem Magnetfeld mit nur einer geringen Eindringtiefe. Dies hat den besonderen Vorteil, dass zwar das Kontaktelement 14, das an der zweiten Lötanschlussfläche 7 anliegende Lotdepot 9 und dadurch mittelbar auch die erste Lötanschlussfläche 6 der Leiterstruktur 3 zuverlässig erwärmt werden, jedoch die Leiterstruktur 3 im Umgebungsbereich der ersten Lötanschlussfläche 6 nur gering erwärmt wird. Dadurch kann eine Schädigung der Leiterstruktur 3 und ein Ablösen der Leiterstruktur 3 von der Scheibe 1 zuverlässig vermieden werden.

Die benötigte Einschaltdauer des Magnetfelds bis zum vollständigen Aufschmelzen des Lotdepots 9 sowie der beste Frequenzbereich lassen sich durch Versuche einfach und gut reproduzierbar ermitteln, sowie durch geeignete Software simulieren. Nach dem Lötvorgang wird das Magnetfeld abgeschaltet (der Schalter 13S geöffnet). Die Scheibe 1 wird noch kurz festgehalten, ebenso der Gegenhalter 18, bis das Lot erstarrt ist und die elektrischen Verbindungen auch ohne zusätzliche mechanische Fixierung halten. Danach wird die Scheibe 1 der weiteren Verarbeitung zugeführt.

Zum Optimieren des Lötvorgangs und zur Vermeidung von Spannungen in der Scheibe 1 und der Leiterstruktur 3 kann es vorteilhaft sein, die Scheibe 1 samt Leiterstruktur 3 im Bereich der ersten Lötanschlussstelle 6 und deren Umgebung vorzuwärmen. Dazu kann beispielsweise eine Heizung 20 unterhalb der Scheibe 1 (d.h. auf der dem Lötwerkzeug 13 und dem Kontaktelement 14 abgewandten Seite) angeordnet werden.

### Bezugszeichen

- 1: Scheibe
- 2: Lötstelle
- 3: Leiterstruktur
- 4: Sammelleiter
- 5: Heizleiter,
- 5': Antennenleiter
- 6: erste Lötanschlussfläche
- 7: zweite Lötanschlussfläche
- 9: Lotdepot
- 11: Auflagemittel
- 13: Lötwerkzeug
- 13C: Rohranschlüsse
- 13G: Generator
- 13I: Induktionsschleife
- 13S: Schalter
- 14: Kontaktelement
- 17: Luftspalt
- 18: Gegenhalter
- 19: elektrische Zuleitung
- 20: Heizung
- 100: Vorrichtung
- Z: Bereich

## Patentansprüche

1. System zum induktiven Verlöten, umfassend:
- mindestens ein Kontaktelement (14), welches eine zweite Lötanschlussfläche (7) enthält,
- mindestens eine Leiterstruktur (3), welche auf einer nichtmetallischen Scheibe (1) angeordnet ist und eine erste Lötanschlussfläche (6) enthält, wobei die erste und zweite Lötanschlussfläche (6, 7) dazu geeignet sind, mit dem Lot aus einem Lotdepot (9) eine Lötstelle (2) auszubilden, und eine
- Vorrichtung zum induktiven Verlöten des mindestens eines Kontaktelements (14) mit der mindestens einen Leiterstruktur (3) auf der nichtmetallischen Scheibe (1), umfassend:
- Mittel (11) zum Festlegen einer Scheibe (1) während des Lötvorgangs,
- mindestens ein Lötwerkzeug (13) mit mindestens einer zum Abstrahlen eines Magnetfeldes geeigneten Induktionsschleife (13I) oder Induktionsspule,
- Mittel zum gegenseitigen Positionieren des Lötwerkzeugs (13) und eines ferromagnetischen Kontaktelements (14), derart, dass das eingeschaltete Magnetfeld des Lötwerkzeugs (13) das Kontaktelement (14) zumindest abschnittsweise erwärmt,
- einen zum Erzeugen einer Wechselspannung mit einer Frequenz von bis zu 1500 kHz geeigneten, mit der Induktionsschleife (13I) oder der Induktionsspule verbindbaren Generator (13G),
**dadurch gekennzeichnet, dass**
das mindestens eine Kontaktelement (14) ferromagnetisch ist,
wobei das Lötwerkzeug (13) neben der Induktionsschleife (13I) oder der Induktionsspule keine Bauelemente zum Lenken und Führen der Feldlinien des Magnetfeldes umfasst, und wobei die Abmessungen der mindestens einen Induktionsschleife (13I) oder Induktionsspule im Wesentlichen der Länge und Breite des Kontaktelements (14) über der Lötstelle (2) entsprechen.

2. System zum induktiven Verlöten nach Anspruch 1, wobei das Lötwerkzeug (13) mehr als eine Induktionsschleife (13I) oder Induktionsspule umfasst.

3. System zum induktiven Verlöten nach einem der Ansprüche 1 bis 2, wobei das Lötwerkzeug (13) mit einer elektrisch isolierenden Zwischenlage zum Anlegen an das Kontaktelement (14) ausgestattet ist.

4. System zum induktiven Verlöten nach einem der Ansprüche 1 bis 3, wobei die Vorrichtung zum induktiven Verlöten einen Roboter zum Führen und Anlegen des mindestens einen Lötwerkzeuges (13) an die Scheibe (1) und/oder der Scheibe (1) an das Lötwerkzeug (13) enthält.

5. System zum induktiven Verlöten nach einem der Ansprüche 1 bis 4, wobei die Vorrichtung zum induktiven Verlöten mindestens einen Gegenhalter (18) zum Aufdrücken des Kontaktelements (14) auf die Scheibe (1) umfasst.

6. System zum induktiven Verlöten nach Anspruch 5, wobei der Gegenhalter (18) mit Greifwerkzeugen zum Positionieren der Kontaktelemente (14) kombiniert ist.

7. System zum induktiven Verlöten nach Anspruch 5 oder 5, wobei der Gegenhalter (18) und gegebenenfalls das Greifwerkzeug keine Bauelemente zum Lenken und Führen der Feldlinien des Magnetfeldes und insbesondere keine ferromagnetischen oder ferritischen Bauelemente aufweist.

8. Verfahren zum induktiven Verlöten mindestens eines ferromagnetischen Kontaktelements (14) mit mindestens einer Leiterstruktur (3) auf einer nichtmetallischen Scheibe (1) in einem System zum induktiven Verlöten nach einem der Ansprüche 1 bis 7, wobei
a) eine nichtmetallische Scheibe (1) mit mindestens einer darauf angeordneten Leiterstruktur (3) und mindestens einer ersten Lötanschlussfläche (6) bereitgestellt wird,
b) mindestens ein Kontaktelement (14) aus einem ferromagnetischen Stahl mit mindestens einer zweiten Lötanschlussfläche (7) bereitgestellt wird,
c) mindestens ein Lotdepot (9) zumindest abschnittsweise auf der ersten Lötanschlussfläche (6) oder der zweite Lötanschlussfläche (7) oder auf beiden angeordnet wird,
d) die zweite Lötanschlussfläche (7) auf der ersten Lötanschlussfläche (6) angeordnet wird, wobei das Lotdepot (9) zumindest abschnittsweise zwischen der ersten Lötanschlussfläche (6) und der zweiten Lötanschlussfläche (7) angeordnet wird,
e) ein Magnetfeld mit einer vorgegebenen Frequenz von einem eine elektrisch gespeiste Schleife (131) oder Spule umfassenden Lötwerkzeug (13) in das Kontaktelement (14) abgestrahlt wird, um dieses durch Induktion zu erhitzen und das daran anliegende Lotdepot (9) aufzuschmelzen.

9. Verfahren nach Anspruch 8, wobei die Frequenz der an die Induktionsschleife (13I) oder Induktionsspule angelegten Wechselspannung an die Anschlussgeometrie angepasst und höchstens bei 1500 kHz eingestellt wird.

10. Verfahren nach Anspruch 9, wobei die Frequenz des Magnetfeldes im Bereich von 5 kHz bis 1100 kHz, bevorzugt von 40 kHz bis 1100 kHz, besonders bevorzugt von 400 kHz bis 1100 kHz und insbesondere von 700 kHz und 1100 kHz eingestellt wird.

11. Verfahren nach einem der Ansprüche 8 bis 10, wobei das Lötwerkzeug (13) unmittelbar oder über mindestens eine elektrisch isolierende Zwischenlage oder mit einem engen Luftspalt (17) oder mit einer Kombination aus mindestens einer elektrisch isolierenden Zwischenlage und einem engen Luftspalt (17) an das Kontaktelement (14) angelegt wird.

12. Verfahren nach einem der Ansprüche 8 bis 11, wobei das Kontaktelement (14) vor und während des Verlötens mithilfe von nichtferromagnetischen, bevorzugt von nichtferromagnetischen nichtmetallischen Gegenhaltern (18) auf der Scheibe (1) fixiert wird.

13. Verfahren nach einem der Ansprüche 8 bis 12, wobei die Scheibe (1), das Kontaktelement (14) und das mindestens eine Lötwerkzeug (13) zumindest während des Lötvorgangs stationär in einer Vorrichtung (100) fixiert werden.

14. Verfahren nach einem der Ansprüche 8 bis 13, wobei die erste Lötanschlussfläche (6) oder die zweite Lötanschlussfläche (7) oder beide mit einem bleihaltigen oder bleifreien Lotdepot (9), bevorzugt mit integriertem oder nachträglich appliziertem Flussmittel versehen werden.

## Claims

1. System for inductive soldering, comprising:
- at least one contact element (14), which contains a second solder connection surface,
- at least one conductor structure (3) that is arranged on a nonmetallic plate (1) and which contains a first solder connection surface (6), wherein the first and second solder connection surfaces (6, 7) are suitable for forming a solder joint with the solder from a solder deposit (2), and a
- device for inductively soldering of the at least one contact element (14) to the at least one conductor structure (3) on the nonmetallic plate (1), comprising:
- means (11) for fastening a plate (1) during the soldering operation,
- at least one soldering tool (13) having at least one induction loop (13I) or induction coil suitable for emitting a magnetic field,
- means for mutually positioning the soldering tool (13) and a ferromagnetic contact element (14), such that the switched-on magnetic field of the soldering tool (13) heats the contact element (14), at least in sections,
- a generator (13G) that is suitable for generating an alternating voltage with a frequency of up to 1500 kHz and that can be connected to the induction loop (13I) or the induction coil, **characterized in that** the contact element (14) is ferromagnetic, and
wherein, apart from the induction loop (13I) or the induction coil, the soldering tool (13) includes no components for directing and guiding the field lines of the magnetic field, and wherein
the dimensions of the at least one induction loop (13I) or induction coil correspond substantially to the length and width of the contact element 14 above the solder joint (2).

2. System for inductive soldering according to claim 1, wherein the soldering tool (13) includes more than one induction loop (13I) or induction coil.

3. System for inductive soldering according to one of claim 1 or 2, wherein the soldering tool (13) is equipped with an electrically insulating intermediate layer for application to the contact element (14).

4. System for inductive soldering according to one of claims 1 through 3, wherein the device for inductive soldering includes a robot for guiding and applying the at least one soldering tool (13) to the plate (1) and/or the plate (1) to the soldering tool (13).

5. System for inductive soldering according to one of claims 1 through 4, wherein the device for inductive soldering includes at least one counterholder (18) for pressing the contact element (14) onto the plate (1).

6. System for inductive soldering according to claim 5, wherein the counterholder (18) is combined with gripping tools for positioning the contact elements (14).

7. System for inductive soldering according to claim 5 or 6, wherein the counterholder (18) and, optionally, the gripping tool have no components for directing and guiding the field lines of the magnetic field and in particular have no ferromagnetic or ferritic components.

8. Method for inductively soldering at least one ferromagnetic contact element (14) to at least one conductor structure (3) on a nonmetallic plate (1) in a system for inductive soldering according to one of claims 1 through 7, wherein
a) a nonmetallic plate (1) having at least one conductor structure (3) arranged thereon and at least one first solder connection surface (6) is provided,
b) at least one contact element (14) made of a ferromagnetic steel and having at least one second solder connection surface (7) is provided,
c) at least one solder deposit (9) is arranged, at least in sections, on the first solder connection surface (6) or the second solder connection surface (7) or on both,
d) the second solder connection surface (7) is arranged on the first solder connection surface (6), wherein the solder deposit (9) is arranged, at least in sections, between the first solder connection surface (6) and the second solder connection surface (7),
e) a magnetic field with a predefined frequency is radiated by a soldering tool (13) comprising an electrically supplied loop (13I) or coil into the contact element (14) in order to heat it by induction and to melt the solder deposit (9) positioned thereon.

9. Method according to claim 8, wherein the frequency of the alternating voltage applied on the induction loop (13I) or induction coil is adapted to the connector geometry and is set at 1500 kHz at most.

10. Method according to claim 9, wherein the frequency of the magnetic field is set in the range from 5 kHz to 1100 kHz, preferably from 40 kHz to 1100 kHz, particularly preferably from 400 kHz to 1100 kHz, and in particular from 700 kHz and 1100 kHz.

11. Method according to one of claims 8 through 10, wherein the soldering tool (13) is applied to the contact element (14) directly or via at least one electrically insulating intermediate layer or with a narrow air gap (17) or with a combination of at least one electrically insulating intermediate layer and a narrow air gap (17).

12. Method according to one of claims 8 through 11, wherein the contact element (14) is fixed on the plate (1) before and during the soldering with the aid of non-ferromagnetic, preferably of non-ferromagnetic nonmetallic counterholders (18).

13. Method according to one of claims 8 through 12, wherein the plate (1), the contact element (14), and the at least one soldering tool (13) are fixed stationarily in a device (100) at least during the soldering operation.

14. Method according to one of claims 8 through 13, wherein the first solder connection surface (6) or the second solder connection surface (7) or both are provided with a lead-containing or lead-free solder deposit (9), preferably with an integrated or subsequently applied flux.

## Revendications

1. Système pour souder par induction comprenant
- au moins un élément de contact (14), qui contient une deuxième surface de connexion à la brasure,
- au moins une structure conductrice (3) disposée sur une plaque non métallique (1) et contenant une première surface de connexion à la brasure (6), dans laquelle les première et deuxième surface de connexion à la brasure (6, 7) sont adaptées à la formation d'un joint de brasure avec la brasure provenant d'un dépôt de brasure (2), et un
- un dispositif pour souder par induction au moins un élément de contact (14) à au moins une structure conductrice (3) sur la plaque non métallique (1), comprenant:
- des moyens (11) pour fixer une plaque (1) pendant l'opération de brasage,
- au moins un outil de brasage (13) comportant au moins une boucle d'induction (13I) ou une bobine d'induction apte à émettre un champ magnétique,
- des moyens pour positionner mutuellement l'outil de brasage (13) et un élément de contact ferromagnétique (14), de sorte que le champ magnétique activé de l'outil de brasage (13) chauffe l'élément de contact (14), au moins par sections,
- un générateur (13G) apte à générer une tension alternative d'une fréquence allant jusqu'à 1500 kHz et pouvant être connecté à la boucle d'induction (13I) ou à la bobine d'induction,
**caractérisé par le fait que** l'élément de contact (14) est ferromagnétique, et
dans lequel, en dehors de la boucle d'induction (13I) ou de la bobine d'induction, l'outil de brasage (13) ne comprend aucun composant permettant de diriger et de guider les lignes du champ magnétique, et dans lequel les dimensions de la boucle d'induction (13I) ou de la bobine d'induction au moins correspondent sensiblement à la longueur et à la largeur de l'élément de contact 14 au-dessus du joint de soudure (2).

2. Système pour souder par induction selon la revendication 1, dans lequel l'outil de brasage (13) comprend plus d'une boucle d'induction (13I) ou d'une bobine d'induction.

3. Système pour souder par induction selon l'une des revendications 1 ou 2, dans lequel l'outil de brasage (13) est équipé d'une couche intermédiaire électriquement isolante à appliquer sur l'élément de contact (14).

4. Système pour souder par induction selon l'une des revendications 1 à 3, dans lequel le dispositif pour souder par induction comprend un robot pour guider et appliquer le au moins un outil de brasage (13) sur la plaque (1) et/ou la plaque (1) sur l'outil de brasage (13).

5. Système pour souder par induction selon l'une des revendications 1 à 4, dans lequel le dispositif pour souder par induction comprend au moins un contre-portefeuille (18) pour presser l'élément de contact (14) sur la plaque (1).

6. Système pour souder par induction selon la revendication 5, dans lequel la contre-pointe (18) est combinée à des outils de préhension pour positionner les éléments de contact (14).

7. Système pour souder par induction selon la revendication 5 ou 6, dans lequel le contre-porte (18) et, éventuellement, l'outil de préhension n'ont pas de composants pour diriger et guider les lignes de champ du champ magnétique et, en particulier, n'ont pas de composants ferromagnétiques ou ferritiques.

8. Procédé pour souder par induction d'au moins un élément de contact ferromagnétique (14) sur au moins une structure conductrice (3) sur une plaque non métallique (1) dans un système pour souder par induction selon l'une des revendications 1 à 7, dans lequel
a) une plaque non métallique (1) sur laquelle est disposée au moins une structure conductrice (3) et au moins une première surface de connexion de soudure (6),
b) au moins un élément de contact (14) en acier ferromagnétique et comportant au moins une deuxième surface de connexion par soudure (7),
c) au moins un dépôt de brasure (9) est disposé, au moins en sections, sur la première surface de connexion de brasure (6) ou sur la deuxième surface de connexion de brasure (7) ou sur les deux,
d) la deuxième surface de connexion (7) est disposée sur la première surface de connexion (6), dans laquelle le dépôt de brasure (9) est disposé, au moins par sections, entre la première surface de connexion (6) et la deuxième surface de connexion (7),
e) un champ magnétique d'une fréquence prédéfinie est rayonné par un outil de brasage (13) comprenant une boucle (13I) ou une bobine alimentée électriquement dans l'élément de contact (14) afin de le chauffer par induction et de faire fondre le dépôt de brasure (9) positionné sur celui-ci.

9. Procédé selon la revendication 8, dans lequel la fréquence de la tension alternative appliquée sur la boucle d'induction (13I) ou la bobine d'induction est adaptée à la géométrie du connecteur et est fixée à 1500 kHz au maximum.

10. Procédé selon la revendication 9, dans lequel la fréquence du champ magnétique est comprise entre 5 kHz et 1100 kHz, de préférence entre 40 kHz et 1100 kHz, de préférence entre 400 kHz et 1100 kHz, et en particulier entre 700 kHz et 1100 kHz.

11. Procédé selon l'une des revendications 8 à 10, dans lequel l'outil de brasage (13) est appliqué à l'élément de contact (14) directement ou par l'intermédiaire d'au moins une couche intermédiaire électriquement isolante ou avec un entrefer étroit (17) ou avec une combinaison d'au moins une couche intermédiaire électriquement isolante et d'un entrefer étroit (17).

12. Procédé selon l'une des revendications 8 à 11, dans lequel l'élément de contact (14) est fixé sur la plaque (1) avant et pendant la soudure à l'aide de contre-porteurs non ferromagnétiques, de préférence non ferromagnétiques et non métalliques (18).

13. Procédé selon l'une des revendications 8 à 12, dans lequel la plaque (1), l'élément de contact (14) et au moins un outil de brasage (13) sont fixés de manière stationnaire dans un dispositif (100) au moins pendant l'opération de brasage.

14. Procédé selon l'une des revendications 8 à 13, dans lequel la première surface de connexion de brasage (6) ou la deuxième surface de connexion de brasage (7) ou les deux sont pourvues d'un dépôt de brasage (9) contenant ou sans plomb, de préférence avec un flux intégré ou appliqué ultérieurement.
